# EUROPÄISCHE PATENTSCHRIFT

(11) **EP 1 655 385 B1**
(45) Veröffentlichungstag und Bekanntmachung des Hinweises auf die Patenterteilung: **05.01.2011**
(21) Anmeldenummer: 04026247.9
(22) Anmeldetag: 05.11.2004
(51) Int. Cl.: C23C 14/00, C23C 14/34, C23C 14/02

(54) **Verfahren zum Aufbringen optischer Beschichtungen**
Method for making optical coatings
Procédé de dépôt de couches optiques

(43) Veröffentlichungstag der Anmeldung: 10.05.2006
(73) Patentinhaber: Satisloh AG, 6340 Baar (CH)
(72) Erfinder: Breme, Frank, 8915 Hausen am Albis (CH)
(74) Vertreter: Schaad, Balass, Menzl & Partner AG

(56) Entgegenhaltungen:
- EP-A- 1 092 787
- WO-A-03/048406
- US-B1- 6 277 507
- PATENT ABSTRACTS OF JAPAN Bd. 2000, Nr. 20, 10. Juli 2001 (2001-07-10) & JP 2001 073130 A (SUMITOMO CHEM CO LTD), 21. März 2001 (2001-03-21)
- FRACASSI F ET AL: "DEPOSITION OF GOLD-CONTAINING SILOXANE THIN FILMS" THIN SOLID FILMS, ELSEVIER-SEQUOIA S.A. LAUSANNE, CH, Bd. 272, Nr. 1, Januar 1996 (1996-01), Seiten 60-63, XP000623627 ISSN: 0040-6090

## Beschreibung

Die Erfindung betrifft ein Verfahren zum Aufbringen einer Beschichtung gemäss Anspruch 1.

Für die Herstellung optischer Beschichtungen, beispielsweise für Ent- und Verspiegelungen, optische Filter und andere Vergütungen von Substratoberflächen werden eine Reihe von Vakuumbeschichtungsverfahren eingesetzt. Zu den in einer Vakuumkammer durchgeführten Vakuumbeschichtungsverfahren zählen unter anderem: das Bedampfen (vapor deposition - VD), die chemische Gasphasenabscheidung (chemical vapor deposition - CVD) und das Sputtern (physical vapor deposition - PVD).

Beim Bedampfen wird zunächst ein Beschichtungsmaterial mittels einer Heizung oder Elektronenstrahlbeschuss geschmolzen und verdampft. Das in der Gasphase befindliche Material kondensiert anschliessend auf einer kühleren Oberfläche des zu beschichtenden Substrates aus und bildet dort eine Schicht. Allerdings erfolgt die Abscheidung auch an anderen, der Gasphase zugänglichen Oberflächen in der Vakuumkammer.

Im Gegensatz zum physikalischen Bedampfungsverfahren wird beim CVD-Verfahren eine sich zunächst in einer Gasphase befindliche Feststoffkomponente auf der Oberfläche des Substrates aufgrund einer chemischen Reaktion abgeschieden. Voraussetzung hierfür ist, dass eine Verbindungen mit den gewünschten Eigenschaften in einer Gasphase existiert, die sich unter bestimmten Bedingungen, etwa bei einem bestimmten Reaktionspartner, als eine feste Schicht abscheidet. Eine spezielle Art des CVD-Verfahrens ist das plasmaunterstützte CVD. Dabei wird oberhalb der zu beschichtenden Substratoberfläche ein Plasma erzeugt. Einige der im eingeleiteten Gas befindlichen Komponenten, werden im Plasma in einen chemisch-reaktiven Zustand versetzt, so dass sie nahe der Substratoberfläche zu einer chemischen Reaktion befähigt werden, die zum Aufbau einer festen Schicht führt.

Als Sputtern bezeichnet man eine Materialabtrag durch Ionenbeschuss, bei dem kleinste Partikel eines beschossenen Festkörpertargets herausgelöst (zerstäubt) werden und - eventuell nach einer Reaktion mit in der Vakuumkammer vorhandenen Sputtergasen - auf einer dem Target direkt gegenüberliegenden Frontfläche eines Substrates kondensieren, wodurch sich eine feste Schicht bildet. Das Sputtern ist ein hauptsächlich physikalisches Beschichtungsverfahren mit einer durch den Ionenbeschuss hervorgerufenen Richtungscharakteristik, bei dem lediglich direkt in Blickrichtung zum Target liegende Bereiche und insbesondere die Frontfläche des Substrats, beschichtet werden.

Mit den genannten Beschichtungsverfahren werden typischer Weise Schichten aus anorganischer Materie, die häufig keramische Eigenschaften aufweisen, aufgebracht. Anorganische Schichten haben jedoch den Nachteil, dass sie im Allgemeinen sehr spröde sind und sich daher beispielsweise zur Aufbringung auf Kunststoffsubstrate mit anderen mechanischen und/oder thermischen Eigenschaften, insbesondere einer von der anorganischen Schicht verschiedenen Elastizität und einem unterschiedlichen Ausdehnungskoeffizienten, nur bedingt eignen. Dies spielt insbesondere bei Brillen- oder Uhrengläsern aus Kunststoff eine Rolle, wo Entspiegelungs- und/oder Antikratzschichten grossen mechanischen und thermischen Belastungen ausgesetzt sind und hohen Anforderungen an die optische Qualität genügen müssen. Grosse Unterschiede in den mechanischen und/oder thermischen Eigenschaften des Substrats und der Funktionsschicht führen zu verminderter Haftung und gegebenenfalls sogar zu einem Abplatzen der Schichten. Das Abplatzen von Schichten etwa von Brillengläsern kann beispielsweise zu einer Sichtbehinderung beim Tragen der Brille führen.

Zur Lösung diese Problems ist es bekannt, Kunststoffoberflächen mittels sogenannter Hartlacke in nasschemischen Verfahren zu versiegeln und damit zu härten. Nach einer derartigen Konditionierung der Oberfläche wird dann eine weitere optische Schicht bzw. ein Schichtsystem beispielsweise mit einem der oben genannten Vakuumbeschichtungsverfahren auf die Hartlackschicht aufgebracht. Allerdings sind diese Hartlackierungen technisch sehr aufwendig, weisen eine geringe Ausbeute an optisch einwandfreien Hartlackschichten auf und besitzen eine geringe Abriebfestigkeit und Witterungsbeständigkeit im Vergleich zu den mittels Vakuumbeschichtungsverfahren aufgebrachten anorganischen Schichten, wie Oxid- oder Nitridschichten. Darüber hinaus ist ein solches zweistufiges Herstellungsverfahren mit erhöhten Kosten aufgrund möglicher Oberflächenkontaminationen und aufwendigerer Handhabungstechniken verbunden.

Ein alternativer Lösungsansatz, der ohne eine separat aufgebrachte Hartlackschicht auskommt, ist aus der EP-A-0870070 bekannt. Bei einem plasma-unterstützten CVD-Verfahren werden dabei zusätzlich zu den Reaktivgasen Sauerstoff und Stickstoff, metallorganische, in einer Gasphase befindliche Monomere in die Vakuumkammer eingeleitet und während des Schichtaufbaus in die Schicht eingebaut. Zum Herstellen einer organisch modifizierten Oxid-, Oxidnitrid oder Nitridschicht wird das metallorganische Monomer Hexamethylendisiloxan (HMDSO) eingesetzt. Bevorzugte Anwendungsgebiete für dieses Verfahren sind Folienbeschichtungen, Fenster- und Spiegelbeschichtungen sowie Beschichtungen von dekorativen Flächen und Fassadenverkleidungen.

Als nachteilig erweist sich bei plasma-unterstützten CVD-Verfahren, dass nicht nur die gewünschten Oberflächen eines Substrates, sondern auch andere Oberflächen in der Vakuumkammer, insbesondere auch Rückseiten der Substrate, beschichtet bzw. unkontrolliert verunreinigt werden. Dies geschieht in jedem Fall, da die Prozessbedingungen so gewählt sind, dass eine chemische Reaktion des Reaktivgases an den Oberflächen stattfindet. Entsprechend fallen dadurch im Produktionsprozess zeit- und kostenintensive Reinigungsarbeiten der Vakuumkammer an. Da eine unkontrollierte Rückseitenbeschichtung die optische Qualität des Endprodukts beeinflusst, sind derartige CVD-Verfahren zur Herstellung optischer Elemente problematisch.

Beim Verfahren gemäss der EP-A-0870070 wird eine gewisse Lokalisierung auf zu beschichtende Oberflächen durch das Erzeugen einer hochdichten Plasmazone unmittelbar vor der zu beschichtenden Oberfläche und durch eine gezielte Hinleitung von Reaktivgasen und Monomeren auf die zu beschichtenden Oberfläche zu erzeugt. Dieses Verfahren ist allerdings technisch aufwendig und verhindert eine Verschmutzung der Vakuumkammer und eine unkontrollierte Rückseitebeschichtung der Substrate nur unzureichend.

WO03/048406 offenbart ein Verfahren zum Aufbringen einer oder mehrerer Beschichtungen auf ein Substrat aus Glas oder Polymermaterialien mittels Zerstäubung eines Targets. In die Vakuumkammer wird gleichzeitig HMDSO und Sputtergas eingeführt.

Die Aufgabe der vorliegenden Erfindung besteht darin, ein Verfahren zur Herstellung von Beschichtungen zu schaffen, welche es unter geringer Verschmutzung einer Vakuumkammer ermöglichen, eine Schicht mit bestimmten mechanischen Eigenschaften auf einer Frontfläche eines Substrats aufzubringen.

Diese Aufgabe wird durch ein Verfahren zum Aufbringen einer Beschichtung gemäss Anspruch 1 gelöst. Besonders bevorzugte Ausbildungsformen sind in den abhängigen Ansprüchen beschrieben.

Das erfindungsgemässe Verfahren dient dem Aufbringen einer optischen Übergangsschicht auf eine Frontfläche eines Substrats. Die Übergangsschicht ist dazu bestimmt, mechanische Eigenschaften des Substrats an mechanische Eigenschaften von oberhalb der Übergangsschicht aufzubringenden Schichten bzw. Schichtsystemen anzupassen. Auf diese Weise wird eine Kompatibilität der Materialien des Substrats und der darüber liegenden Schichten in Hinblick auf deren Elastizität, Härte und thermischen Eigenschaften erreicht. Den Basisprozess zum Aufbringen der Übergangsschicht bildet das Sputtern. Das Sputtern bietet den Vorteil eines schnellen Schichtaufbaus verbunden mit einer ausgezeichneten Richtungscharakteristik, wodurch Verschmutzungen der Vakuumkammer weitgehend verhindert werden. Während des Sputterns zum Aufbau der Übergangsschicht werden Precursoren, deren Reaktionsprodukte im in die Übergangsschicht eingebauten

Zustand die mechanischen Eigenschaften der Übergangsschicht verändern, in die Vakuumkammer eingeleitet. Die Konzentration von den in einer Gasphase vorliegenden Precursoren ist in der Vakuumkammer derart eingestellt, dass die Abscheidung von Reaktionsprodukten und/oder Precursoren ohne gleichzeitigen Sputtervorgang, also im Sinne des CVD-Verfahrens, weitgehend unterdrückt ist bzw. nicht stattfindet. Das heisst, bezüglich der Reaktionsprodukte und der Precursoren herrscht ohne Sputtervorgang ein Gleichgewicht von Adsorption und Desorption, während beim Sputtervorgang auf den dem Target gegenüberliegenden Bereichen, insbesondere den zu beschichtenden Flächen die Desorption behindert bzw. die Adsorption befördert ist. Auf diese Weise erfolgt eine Abscheidung von Reaktionsprodukten und/oder Precursoren zielgerichtet und wenigstens nahezu ausschliesslich im dem Target gegenüberliegenden Bereich und dabei insbesondere auf den Frontflächen der Substrate; die umliegenden Oberflächen in der Vakuumkammer und die Rückseite des Substrats werden deutlich weniger verschmutzt.

Gegebenenfalls können ohne eine Umbettung des Substrates weitere Beschichtungen mittels Sputtern in der Vakuumkammer erfolgen. Beispielsweise ist es möglich, in einem Arbeitsgang mit dem gleichen Target, zum Beispiel einem Si-Target, die Übergangsschicht und darauf ein Si-Oxid/Si-Nitrid-Schichtsystem zur Entspiegelung auf Brillen- oder Uhrengläser aufzubringen. Ein derartiges Verfahren zum Aufbringen von Schutz- und Enstspiegelungsschichten ist beispielsweise in der EP-A-1275751 beschrieben.

Das erfindungsgemässe Verfahren stellt somit eine qualitativ hochwertige Beschichtung, insbesondere auch für optische Komponenten, in einem zeit- und kostensparenden Produktionsverfahren sicher. Im Gegensatz zum Stand der Technik handelt es sich nicht um ein rein chemisches Verfahren sondern um eine Kombination vom physikalischen Sputtern mit einer ausgeprägten Richtungscharakteristik und dem chemisch-reaktiven Einbau von Reaktionsprodukten in die Übergangsschicht.

Anhand von Zeichnungen werden nachfolgend besonders bevorzugte Ausführungsformen des erfindungsgemässen Verfahrens beschrieben.

Es zeigen im Einzelnen rein schematisch:
- Fig. 1: in einer Seitenansicht einen Querschnitt eines beschichteten Substrats mit einer Übergangsschicht, in welche Reaktionsprodukte eingebaut sind;
- Fig. 2: in einer Detaildarstellung das in Fig. 1 gezeigte Substrat mit einer Übergangsschicht und einem darüber aufgebrachten Schichtsystem zur Entspiegelung; und
- Fig. 3: in einer Draufsicht eine Vorrichtung mit zwei Substraten und einem Target in einer Vakuumkammer.

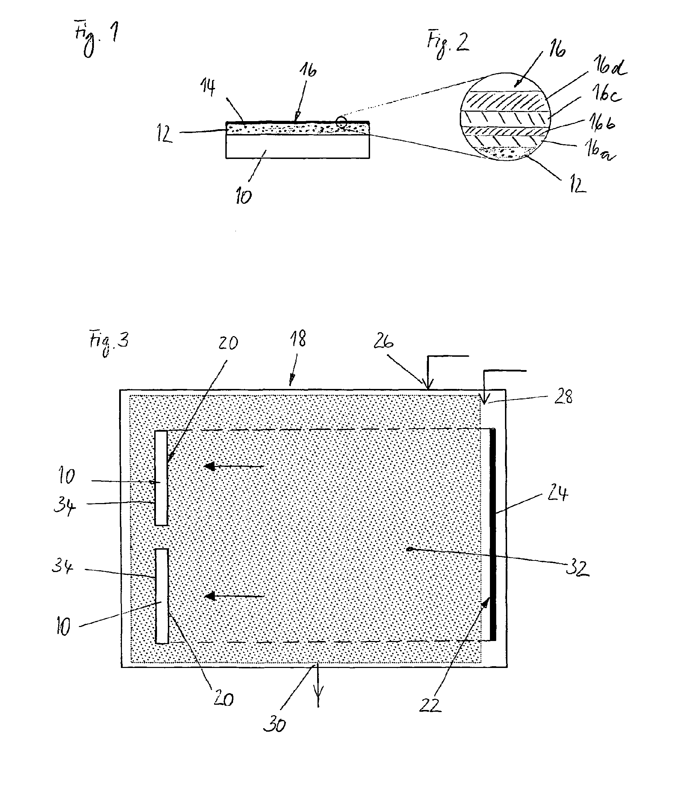

In Fig. 1 ist ein Substrat 10 mit einer Beschichtung, die nach dem erfindungsgemässen Verfahren hergestellt worden ist, gezeigt. Direkt oberhalb des Substrats 10 ist eine Übergangsschicht 12 (auch Hartschicht genannt) dargestellt, in welche aus Precursoren entstandene Reaktionsprodukte 14 eingebaut sind. Die Reaktionsprodukte 14 dienen dazu, die mechanischen und thermischen Eigenschaften des Substrats 10 an die mechanischen und thermischen Eigenschaften eines darüber liegenden Schichtsystems 16 zur Entspiegelung anzupassen. Auf diese Weise wird eine mechanische Kompatibilität des Substrats 10 zum Schichtsystems 16 gewährleistet. Eine erhöhte Elastizität und damit eine verbesserte Anpassungsfähigkeit der Übergangsschicht 12 verhindert ein Ablösen des im Allgemeinen sehr spröden, anorganischen Schichtsystems 16. Die Übergangsschicht übt somit eine Brückenfunktion zwischen dem Substrat 10 und dem Schichtsystem 16 aus.

Die in Fig. 1 gezeigte, auf einem Substrat 10 aus Kunststoff aufgetragene und sandwich-artig eingefasste Übergangsschicht 12 besteht hauptsächlich aus SiO₂ und weist eine Dicke von etwa 500 nm auf. Das oberhalb dieser Übergangsschicht 12, im Detail in Fig. 2 dargestellte Schichtsystem 16 zur Entspiegelung hat eine Dicke von etwa 214 nm und besteht aus einer etwa 33 nm dicken SiNy-Schicht 16a , einer etwa 22 nm dicken SiOₓ-Schicht 16b, einer weiteren, etwa 66 nm dicken SiN_{y}-Schicht 16c und einer weiteren, etwa 94 nm dicken SiOₓ-Schicht 16d. Da bei der Herstellung der Übergangsschicht 12 und des Schichtsystems 16 das gleiche Targetmaterial Silizium sowie die Sputtergase Sauerstoff und Stickstoff Verwendung fanden, sind die Schichten 12, 16a, 16b, 16c, 16d in einem einzigen Arbeitsgang ohne Umbettung des Substrats 10 sukzessive abgeschieden worden. Das Verfahren zum Aufbringen der Entspiegelung ist beispielsweise in der bereits erwähnten EP-A-1275751 beschrieben. Neben der hier gezeigten Beschichtung eines Substrats 10 aus Kunststoff, können auch andere Substratmaterialien, beispielsweise Glas, Metalle oder keramische Werkstoffe derart beschichtet werden. Darüber hinaus kann bei der Beschichtung durch Variation der Precursorenkonzentration ein bestimmter Konzentrationsgradient von Reaktionsprodukten 14 in der Übergangsschicht 12 erzeugt werden, um die mechanische Kompatibilität zwischen Substrat 10 und Schichtsystem 16 weiter zu optimieren.

In Fig. 3 ist rein schematisch eine Draufsicht auf die Vorrichtung dargestellt. Im Innern einer von Wänden gebildeten Vakuumkammer 18 befinden sich zwei Substrate 10, die mit ihren in den Innenraum der Vakuumkammer 18 gerichteten Frontflächen 20 einer Targetfläche 22 eines Targets 24 wenigstens nahezu parallel gegenüberliegen. Der Abstand zwischen den Frontflächen 20 und der Targetfläche beträgt dabei je nach Substrat zwischen 50 mm und 150 mm, vorzugsweise zwischen 90 mm und 120 mm.

Bei dem vorgestellten Ausführungsbeispiel handelt es sich um ein Si-Target. Einsetzbar sind natürlich auch andere, zum Sputtern geeignete Materialen. Targetflächenseitig wird mittels einer nicht gezeigten Vorrichtung der Beschuss des Targets 24 mit Ionen bewirkt. Dies kann auf eine für klassische Sputterverfahren bekannte Art und Weise, beispielsweise mittels einer Gleichspannung-Gasentladung oder mittels eines am Target 24 positionierten, gepulst betriebenen Magnetrons erfolgen.

In der Nähe der Targetfläche 22 wird in einem durch einen Sputtergaseinlass 26 in die Vakuumkammer 18 eingeleiteten Sputtergas, in dieser Ausführung Argon und Sauerstoff, die Ausbildung eines Plasmas, das Ionen der Sputtergase enthält, bewirkt. Die Ionen werden in einem elektromagnetischen Feld zur Targetfläche 22 hin beschleunigt. Beim Auftreffen der Ionen werden (Si-)Atome aus dem Target 24 herausgelöst. Entsprechend der Impulserhaltung bewegen sich die herausgeschlagenen Atome im Wesentlichen nahezu senkrecht von der Targetfläche 22 weg auf die Frontfläche 20 des Substrates 10 zu und bedingen damit eine Richtungsabhängigkeit des Beschichtungsprozesses beim Sputtern. Auf ihrem Weg werden sie durch den Sauerstoff oxidiert, im vorliegenden Fall zu SiO₂, und anschliessend auf bzw. oberhalb der Frontfläche 20 des Substrates 10 abgeschieden.

Die Vakuumkammer 18 weist neben dem Sputtergaseinlass 26 zum Einleiten des Sputtergases auch wenigstens einen Precursoreinlass 28 und einen Auslass 30 auf.

Über den Precursoreinlass 28 werden die in einer Gasphase vorliegenden Precursoren, den Vorstufen der Reaktionsprodukte 14, der Vakuumkammer 18 zugeführt. Im Zusammenwirken mit dem an eine Vakuumpumpe angeschlossenen Auslass 30 wird die Konzentration der Precursoren bzw. deren zugehöriger Partialdruck über eine nicht gezeigte Steuerungsvorrichtung eingestellt. Bei der vorliegenden Ausführung wird als Precursor Hexamethylendisiloxan (HMDSO) verwendet. Alternativ können natürlich auch andere in einer Gasphase vorliegende Stoffe bzw. Stoffgemische, vorzugsweise metallorganische Stoffe zur Anwendung gelangen. Der Durchfluss der Precursors HMDSO ist bei dieser Ausführung mit einer 10 dm³ grossen Vakuumkammer 18 auf etwa 5 sccm (Standardkubikzentimeter/min) bzw. entsprechend 0,3 Normliter/h eingestellt, was einen Partialdruck der Precursoren in der Vakuumkammer 18 von 1,5·10⁻² Pa zur Folge hat. Bei einem derartig geringen Partialdruck bzw. einer so geringen Konzentration von

Precursoren werden beim Sputtern nahezu ausschliesslich die der Targetfläche 22 direkt gegenüberliegenden Frontflächen 20 der Substrate 10 unter Einbau der Reaktionsprodukte 14 beschichtet. Die geringe Konzentration von Precursoren bedingt weiter, dass im Fall von einem fehlenden Ionenbeschuss, beispielsweise bei einem Fehlen des Plasmas aufgrund einer ausgeschalteten Gasentladung, einem nicht im Betrieb befindlichen Magnetron oder/und fehlenden Sputtergasen, in der gesamten Vakuumkammer 18 Ad- und Desorptionsprozesse im Gleichgewicht stehen und es zu keinem Einbau bzw. keiner effektiven Ablagerung, im Sinne einer Verschmutzung mit Precursoren bzw. deren Reaktionsprodukten 14 kommen kann.

Erst während des Sputterns und damit beim Aufbau der Übergangsschicht 12 wird wenigstens nahezu ausschliesslich im dem Target 24 gegenüberliegenden Bereich, insbesondere auf bzw. vor den Frontflächen 20 dieses Gleichgewicht derart verschoben, dass es zu einer Nettoabscheidung der Reaktionsprodukte 14 durch eine behinderte Desorption bzw. beförderte Absorption und somit zum Einbau der Reaktionsprodukte 14 in die Übergangsschicht 12 kommt. Auf allen nicht dem Target 24 bzw. der Targetfläche 22 gegenüberliegenden Oberflächen in der Vakuumkammer 18 herrscht weiterhin ein Gleichgewicht von Ad- und Desorptionsprozessen und es erfolgt keine bzw. eine verminderte Abscheidung bzw. Verschmutzung.

Basierend auf der Richtungsabhängigkeit des Beschichtungsprozesse beim Sputtern verfügt das erfindungsgemässe Verfahren über eine ausgeprägte Richtungscharakteristik in Blickrichtung von der Targetfläche 22 zu den Frontflächen 20 hin, die es vorteilhaft ermöglicht, unerwünschte Abscheidungen von Precursoren bzw. Reaktionsprodukten 14, insbesondere auch auf den Rückseiten 34 der Substrate 10 zu verhindern. Eine unkontrollierte Rückseitenbeschichtung würde zu partiell ungenügenden Haftfestigkeiten auf den Rückseiten 34 führen, so dass ein anschliessendes Aufbringen weiterer Schichten bzw. Schichtsysteme auf die fehlerhafte Rückseitenbeschichtung insgesamt Beschichtungen mit lediglich unzureichender Qualität liefert.

Das erfindungsgemässe Verfahren zum Betrieb der oben beschriebenen Vorrichtung erfordert zunächst auch die von bekannten Vakuumbeschichtungsverfahren notwendigen Vorbereitungsarbeiten, also im Wesentlichen ein Reinigen der Vakuumkammer 18, eine Konditionierung/Reinigung der Substratoberflächen, eine Befestigung/Ausrichtung von Substrat 10 und Target 24, ein Verschliessen der Vakuumkammer 18 und ihre anschliessende Evakuierung. Danach erfolgt die erfindungsgemässe Beschichtung durch Aufbringen der Übergangsschicht 12 auf der Frontfläche 20 des Substrats 10 unter dem Einbau der Reaktionsprodukte 14, um die mechanischen Eigenschaften des nachfolgend aufgebrachten Schichtsystems 16 den mechanischen und/oder thermischen Eigenschaften des Substrates 10 anzugleichen. Beim Sputtern wird die Übergangsschicht 12 unter Einbau der Reaktionsprodukte 14 wenigstens nahezu ausschliesslich auf der Frontfläche 20 abgeschieden. Der Partialdruck der Precursoren in der Vakuumkammer 18 wird bei diesem Verfahrensschritt in einem Bereich von 1·10⁻³ Pa bis 1·10⁻¹ Pa, vorzugsweise auf 1,5·10⁻² Pa eingestellt, so dass ohne einen Ionenbeschuss der Targetfläche 22 eine Abscheidung von Reaktionsprodukten 14 und deren Precursoren in der Vakuumkammer 18 verhindert ist. Sobald die Übergangsschicht 12 fertiggestellt ist, kann ohne aufwendiges und kostenintensives Umbetten des Substrates 10 das Schichtsystem 16 aufgebracht werden.

An Substraten 10 die nach dem erfindungsgemässen Verfahren mit einer Übergangsschicht 12 beschichtet und anschliessend mit einem Schichtsystem 16 zur Entspiegelung versehen wurden, sind eine Reihe von Belastungstest durchgeführt worden. Dazu wurden jeweils auf ein Objekt A eine Übergangsschicht 12 bei den folgenden Prozessparametern aufgebracht:
- Gaszuflüsse: 25 sccm Argon, 15 sccm Sauerstoff, 5 sccm HMDSO, woraus ein HMDSO-Partialdruck von 1,5·10⁻² Pa resultiert;
- gepulstes Gleichstromsputtern mit einer elektrischen Leistung von 1,5 kW und einer Pulsfrequenz von 90 kHz, wobei während der Pulse die Plasma-An-Zeit 6 ms beträgt;
- Si-Target 24;
- Zeitdauer zum Aufbringen der Übergangsschicht 12 von 300 ms, woraus eine Dicke der Übergangsschicht 12 von 430 nm resultiert;
- Abstand zwischen dem Si-Target 24 und dem Substrat 10 von 105 mm

Auf das Objekt A und ein Referenzobjekt B, mit einem identischen Substrat 10 aber ohne die Übergangsschicht 12, wurden anschliessend identische Schichtsysteme 16 zur Entspiegelung abgeschieden. Die Beschichtungen wurden dann mittels eines Standardwerkzeuges derart definiert verletzt, dass vier, in einem Abstand von 1 mm zueinander parallel verlaufende Streifen keilförmiger Riefen in die Beschichtungen eingekratzt wurden. Das Objekt A und das zugehörige Referenzobjekt B wurde nachfolgend einem Schnellalterungstest, bei dem eine zweijährige typische Normalbelastung durch eine zehntägige Schnellalterung simuliert wurde, unterzogen. In einer Testkammer wurden die Objekte zu diesem Zweck einem 4-stündigen Wechsel von jeweils
1. einer Temperatur von 55°C und einer Luftfeuchte von 95%, und
2. einer Temperatur von 50°C ohne Luftbefeuchtung aber einer Bestrahlung mit UVB-Licht einer Beleuchtungsstärke von 0,83 W/m²/nm ausgesetzt.

Mittels eines standardisierten Klebestreifen-Tests (ASTM D 3359: Standard Test Methods for Measuring Adhesion by Tape Tests), bei dem Klebestreifen über die verletzten Bereiche aufgeklebt und anschliessend abgezogen wurden, konnten Ablösungen der Beschichtungen durch eine visuelle Kontrolle ermittelt werden. Dabei wurde festgestellt, dass die erfindungsgemäss mit einer Übergangsschicht 12 versehenen Objekte A keine zusätzlichen Beschädigungen und Ablösungen von Schichtelementen aufwiesen. Im Gegensatz dazu lösten sich etwa 30% der Beschichtungen des Referenzobjektes B ab und die verbleibende Beschichtung zeigte weitere Rissbildungen. Auf diese Weise wurde die Funktion und die vorteilhafte Wirkung des erfindungsgemässen Verfahrens mit dem Aufbringen einer Übergangsschicht 12 nachgewiesen.

Ein typisches Einsatzgebiet für die vorliegende Vorrichtung bzw. das vorliegende Verfahren ist die Beschichtung von Brillen- und/oder Uhrengläsern aus Kunststoff oder Glas. Sowohl das Verfahren als auch die Vorrichtung sind jedoch nicht auf die klassischen Gebiete der Optik und des wissenschaftlichen Gerätebaus beschränkt, sondern können auch in anderen Gebieten, beispielsweise der Verpackungstechnik und der Energietechnik, etwa im Zusammenhang mit Solarzellen, Anwendung finden.

## Patentansprüche

1. Verfahren zum Aufbringen optischer Beschichtungen auf eine Frontfläche (20) eines sich dabei in einer Vakuumkammer (18) befindlichen Substrats (10) mittels Ionenbeschuss-unterstütztem Zerstäuben eines Targets (24) (Sputtern), **dadurch gekennzeichnet, dass** zur Herstellung einer frontseitigen Übergangsschicht (12), die einer Angleichung von mechanischen Eigenschaften des Substrats (10) an mechanische Eigenschaften darauf aufzubringender Schichten bzw. Schichtsysteme (16) dient, vor und/oder während des Aufbringens der Übergangsschicht (12) Precursoren, deren Reaktionsprodukte (14) im in die Übergangsschicht (12) eingebauten Zustand die mechanischen Eigenschaften der Übergangsschicht (12) verändern, in die Vakuumkammer (18) eingeleitet werden, wobei in der Vakuumkammer (18) eine Konzentration von den in einer Gasphase vorliegenden Precursoren derart eingestellt ist, dass die Abscheidung von Reaktionsprodukten (14) und/oder Precursoren ohne gleichzeitigen Sputtervorgang im Wesentlichen unterdrückt ist, und dass während des Sputterns eine Abscheidung von Reaktionsprodukten (14) und/oder Precursoren im Wesentlichen in einem dem Target (24) gegenüberliegenden Bereich, vorzugsweise der Frontflächen (20) des Substrats (10), erfolgt.

2. Verfahren nach Anspruch 1, **dadurch gekennzeichnet, dass** als Precursoren polymerisierbare Kohlenwasserstoffe, metallorganische Verbindungen, siliziumorganische Verbindungen, fluororganische Verbindungen bzw. Mischungen davon, vorzugsweise Hexamethylendisiloxan (HMDSO), eingesetzt werden.

3. Verfahren nach Anspruch 1 oder 2, **dadurch gekennzeichnet, dass** als Precursor Hexamethylendisiloxan (HMDSO) verwendet wird, dessen Partialdruck in der Vakuumkammer (18) auf einen Bereich von 1·10⁻³ Pa bis 1·10⁻¹ Pa, vorzugsweise von 1,5·10⁻² Pa, eingestellt ist.

4. Verfahren nach einem der Ansprüche 1 bis 3, **dadurch gekennzeichnet, dass** die Übergangsschicht (12), insbesondere zur Herstellung eines optischen Elements, auf ein optisch transparentes Substrat (10) aus Kunststoff oder Glas aufgebracht wird.

5. Verfahren nach einem der Ansprüche 1 bis 4, **dadurch gekennzeichnet, dass** auf die Übergangsschicht (12) eine weitere Schicht bzw. ein weiteres Schichtsystem (16), vorzugsweise eine Entspiegelungsschicht bzw. ein Entspiegelungsschichtsystem, mittels Sputtern und/oder einem anderen Beschichtungsverfahren aufgebracht wird.

6. Verfahren nach einem der Ansprüche 1 bis 5, **dadurch gekennzeichnet, dass** zum Sputtern Sputtergase in die Vakuumkammer (18) eingeleitet werden.

7. Verfahren nach Anspruch 6, **dadurch gekennzeichnet, dass** als Sputtergase Sauerstoff und Stickstoff verwendet werden.

8. Verfahren nach einem der Ansprüche 1 bis 7, **dadurch gekennzeichnet, dass** das Material des Targets (24) Silizium ist.

## Claims

1. Process for applying optical coatings to a front surface (20) of a substrate (10) located in a vacuum chamber (18) by means of ion-enhanced atomization of a target (24) (sputtering), **characterized in that** to produce a transition layer (12) on the front side, which serves to match mechanical properties of the substrate (10) to mechanical properties of layers or layer systems (16) to be applied to it, precursors whereof the reaction products (14), in the state in which they are incorporated in the transition layer (12), alter the mechanical properties of the transition layer (12) are introduced into the vacuum chamber (18) before and/or during the application of the transition layer (12), with the concentration of the precursors, which are in a vapor phase, in the vacuum chamber (18) being set in such a manner that the deposition of reaction products (14) and/or precursors without a simultaneous sputtering operation is essentially prevented, and that, during sputtering, reaction products (14) and/or precursors are deposited essentially in a region, preferably of the front surfaces (20) of the substrate (10), which lies opposite the target (24).

2. Process according to Claim 1, **characterized in that** the precursors used are polymerizable hydrocarbons, organometal compounds, organosilicon compounds, organofluorine compounds and/or mixtures thereof, preferably hexamethylenedisiloxane (HMDSO).

3. Process according to Claim 1 or 2, **characterized in that** the precursor used is hexamethylenedisiloxane (HMDSO), the partial pressure of which in the vacuum chamber (18) is set to a range from 1·10⁻³ Pa to 1·10⁻¹ Pa, preferably 1.5·10⁻² Pa.

4. Process according to one of Claims 1 to 3, **characterized in that** the transition layer (12), in particular to produce an optical element, is applied to an optically transparent substrate (10) made from plastic or glass.

5. Process according to one of Claims 1 to 4, **characterized in that** a further layer or a further layer system (16), preferably an antireflection layer or antireflection layer system, is applied to the transition layer (12) by means of sputtering and/or another coating process.

6. Process according to one of Claims 1 to 5, **characterized in that** sputtering gases are introduced into the vacuum chamber (18) for the sputtering.

7. Process according to Claim 6, **characterized in that** the sputtering gases used are oxygen and nitrogen.

8. Process according to one of Claims 1 to 7, **characterized in that** the material of the target (24) is silicon.

## Revendications

1. Procédé d'application de revêtements optiques sur une surface frontale (20) d'un substrat (10), qui à cet effet se trouve dans une chambre à vide (18) au moyen d'une pulvérisation assistée par bombardement d'ions d'une cible (24) (pulvérisation cathodique), **caractérisé en ce que** pour la création d'une couche de transition (12) frontale, destinée à adapter les caractéristiques mécaniques du substrat (10) à des caractéristiques mécaniques de couches ou de systèmes de couches (16) destiné(e)s à être appliqué(e)s sur ce dernier, avant et/ou pendant l'application de la couche de transition (12), on introduit dans la chambre à vide (18) des précurseurs, dont les produits réactifs (14) modifient à l'état incorporé dans la couche de transition (12) les caractéristiques mécaniques de la couche de transition (12), une concentration des précurseurs présents dans une phase gazeuse étant réglée dans la chambre à vide (18) de sorte que la séparation de produits réactifs (14) et/ou de précurseurs sans processus de pulvérisation cathodique simultané est sensiblement supprimée et **en ce que** pendant la pulvérisation cathodique, une séparation de produits réactifs (14) et/ou de précurseurs s'effectue sensiblement dans une zone opposée à la cible (24), de préférence dans les surfaces frontales (20) du substrat (10).

2. Procédé selon la revendication 1, **caractérisé en ce qu'**on met en oeuvre en tant que précurseurs des hydrocarbures polymérisables, des composés organométalliques, des composés organosiliciés des composés fluoroorganiques ou des mélanges de ces derniers, de préférence de l'hexaméthylènedisiloxane (HMDSO).

3. Procédé selon la revendication 1 ou 2, **caractérisé en ce qu'**on met en oeuvre en tant que précurseur de l'hexaméthylènedisiloxane (HMDSO) dont la pression partielle dans la chambre à vide (18) est réglée dans un ordre de 1·10⁻³ Pa à 1.10⁻¹ Pa, de préférence à 1,5·10⁻² Pa.

4. Procédé selon l'une quelconque des revendications 1 à 3, **caractérisé en ce que** la couche de transition (12), est appliquée notamment pour la création d'un élément optique sur un substrat (10) optiquement transparent, en matière plastique ou en verre.

5. Procédé selon l'une quelconque des revendications 1 à 4, **caractérisé en ce qu'**on applique sur la couche de transition (12) une couche supplémentaire ou un système de couches supplémentaire (16), de préférence une couche antireflet ou un système de couches antireflet, par pulvérisation cathodique et/ou par un autre procédé de revêtement.

6. Procédé selon l'une quelconque des revendications 1 à 5, **caractérisé en ce que** pour la pulvérisation cathodique, on introduit dans la chambre à vide (18) des gaz de pulvérisation cathodique.

7. Procédé selon la revendication 6, **caractérisé en ce qu'**on utilise en tant que gaz de pulvérisation cathodique de l'oxygène et de l'azote.

8. Procédé selon l'une quelconque des revendications 1 à 7, **caractérisé en ce que** la matière de la cible (24) est du silicium.
